# EUROPEAN PATENT APPLICATION

(11) **EP 4 297 098 A2**
(43) Date of publication of application: **27.12.2023**
(21) Application number: 23173204.1
(22) Date of filing: 12.05.2023
(51) Int. Cl.: H01L 29/66, H01L 29/93, H01L 29/94

(54) **VARACTOR DEVICE WITH BACKSIDE ELECTRICAL CONTACT**

(30) Priority: 24.06.2022 US 202217848660
(71) Applicant: INTEL Corporation, Santa Clara, CA 95054 (US)
(72) Inventor: KAR, Ayan, Portland, 97229 (US); KOLLURU, Kalyan C., Portland, 97214 (US); THOMSON, Nicholas A., Hillsboro, 97124 (US); NEELI, Vijaya Bhaskara, Portland, 97229 (US); RAMI, Said, Portland, 97229 (US); MORARKA, Saurabh, Portland, 97229 (US); KRISHASWAMY, Karthik, Portland, 97210 (US); KOBRINSKY, Mauro J., Portland, 97229 (US)
(74) Representative: 2SPL Patentanwälte PartG mbB

(57) **Abstract**

A varactor device includes a support structure, an electrically conductive layer at the backside of the support structure, two semiconductor structures including doped semiconductor materials, two contact structures, and a semiconductor region. Each contract structure is electrically conductive and is connected to a different one of the semiconductor structures A contract structure couples the corresponding semiconductor structure to the electrically conductive layer. The semiconductor region is between the two semiconductor structures and can be connected to the two semiconductor structures. The semiconductor region may include non-planar semiconductor structures coupled with a gate. The gate may be coupled to another electrically conductive layer at the frontside of the support structure. The varactor device may further include a pair of additional semiconductor regions that are electrically insulated from each other. The additional semiconductor regions may be coupled to two oppositely polarized gates, respectively.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking semiconductor size allows for the incorporation of an increased number of electronic devices (e.g., transistors, diodes, capacitors, varactor devices, etc.) on a chip, lending to the fabrication of products with increased capacity. The drive for ever-more capacity, however, is not without issue. The necessity to optimize the performance of the electronic devices becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an electrical contact structure that couples a semiconductor structure to a backside metal layer, according to some embodiments of the disclosure.
FIG. 2 is a cross-sectional view of a varactor device without backside electrical contact, according to some embodiments of the disclosure.
FIG. 3 is a cross-sectional view of a two-terminal varactor device with backside electrical contact, according to some embodiments of the disclosure.
FIG. 4 is another cross-sectional view of the two-terminal varactor device in FIG. 3, according to some embodiments of the disclosure.
FIG. 5 is a cross-sectional view of another two-terminal varactor device with backside electrical contact, according to some embodiments of the disclosure.
FIG. 6 is a cross-sectional view of a three-terminal varactor device with backside electrical contact, according to some embodiments of the disclosure.
FIG. 7 is another cross-sectional view of the three-terminal varactor device in FIG. 6, according to some embodiments of the disclosure.
FIG. 8 is yet another cross-sectional view of the three-terminal varactor device in FIG. 6, according to some embodiments of the disclosure.
FIG. 9 is yet another cross-sectional view of the three-terminal varactor device in FIG. 6, according to some embodiments of the disclosure.
FIG. 10 is a cross-sectional view of another three-terminal varactor device with backside electrical contact, according to some embodiments of the disclosure.
FIGS. 11A-11B are top views of a wafer and dies that may include one or more varactor devices with backside electrical contact, according to some embodiments of the disclosure.
FIG. 12 is a side, cross-sectional view of an example integrated circuit (IC) package that may include one or more IC devices having varactor devices with backside electrical contact, according to some embodiments of the disclosure.
FIG. 13 is a cross-sectional side view of an IC device assembly that may include components having one or more IC devices implementing varactor devices with backside electrical contact, according to some embodiments of the disclosure.
FIG. 14 is a block diagram of an example computing device that may include one or more components with varactor devices with backside electrical contact, according to some embodiments of the disclosure.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

A varactor device includes a diode designed to provide voltage-controlled variable capacitance. A varactor device may be a varicap diode, varactor diode, variable capacitance diode, variable reactance diode or tuning diode. Varactor devices can provide a method of varying the capacitance within a circuit by the application of a control voltage. Varactor devices can be used for automatic tuning, frequency modulation, and equalization in various circuits, such as radio frequency (RF) circuits, such as voltage-controlled oscillators, RF filters, frequency/phase modulators, and so on.

Key parameters for varactor devices include capacitance ratio and Q factor. The capacitance ratio of a varactor device is the ratio of the maximum capacitance of the varactor device to the minimum capacitance of the varactor device. The capacitance of a varactor device can change in the range between the minimum capacitance and the maximum capacitance. The capacitance ratio indicates the range of capacitance of the varactor device. The capacitance ratio can also be used as an indicator of the signal-to-noise ratio of the varactor device. The Q factor is an indicator of reduction in phase noise produced in a circuit including the varactor device. The Q factor depends on the resistance of the varactor device. The lower the resistance, the higher the Q factor. The larger the capacitance ratio, the larger the range of capacitance.

Currently available technologies for forming varactor devices rely on inter-diffused well design in thick silicon (Si) substrate. However, the inter-diffused well design can fail when the Si substrate is removed. Also, conventional varactor devices usually use frontside trench contact and feedthrough vias to route signal and power between the active structure (e.g., semiconductor structure) and backside metal. The trench contact and feedthrough vias can cause high parasitic resistance and high minimum capacitance. Consequently, the capacitance ratio and Q factor of the varactor device can be undermined. Therefore, improved designs for varactor devices are needed.

Embodiments of the present disclosure may improve on at least some of the challenges and issues described above by providing varactor devices with backside electrical contacts. An example varactor device includes a support structure (e.g., a substrate, a die, a wafer, a carrier substrate, etc.) having a backside and a frontside, one or more semiconductor structures coupled to a ground plane, and one or more semiconductor regions coupled to a signal plane. During operation of the varactor device, the ground plane is grounded, and the signal plane receives an electrical signal. The capacitance of the varactor device can change as the electrical signal changes. The ground plane may be arranged at the backside of the support structure, and the signal plane may be arranged at the frontside of the support structure. Each semiconductor structure may include a semiconductor material with a certain type of dopant, such as n-type or p-type. Each semiconductor structure can be paired with a different contact structure (also referred to as "backside electrical contact") and be coupled to the ground plane through the backside electrical contact. The backside electrical contact may be at least partially buried in the support structure. An example of the backside electrical contact is a via. By using the backside electrical contact, the electrical connection route between the semiconductor structures and the ground plane is minimized, which can minimize the resistance and the minimum capacitance of the varactor device, thereby improving the Q factor and capacitance ratio of the varactor device.

The performance of the varactor device can be also enhanced through gates coupled to the semiconductor regions. A semiconductor region may be coupled to a gate. During operation of the varactor device, the gate can be electrically polarized. For instance, the gate can be coupled to a positive or negative electrical terminal, or the gate can receive positive or negative charges. In some embodiments, such as embodiments where the varactor device has a two-terminal design, the gates of all the semiconductor regions may be electrically coupled to a same signal plane and receive the same electrical signal. In alternative embodiments, such as embodiments where the varactor device has a three-terminal design, the varactor device may include a semiconductor region between two semiconductor structures and a plurality of other semiconductor regions. Some of the other semiconductor regions may be coupled to a first signal plane that provides a first signal, and the rest of the other semiconductor regions may be coupled to a second signal plane that provides a second signal. Semiconductor regions receiving the first signal may alternate with semiconductor regions receiving the second signal.

In some embodiments, the gates can be formed through EUV (extreme ultraviolet) patterning that can provide wider critical dimension for the gates than other patterning technologies. As the gates are wider, the gap between the gates is narrower, and the conduction path between the opposing signals is reduced, thereby reducing the resistance and improving the Q factor of the varactor device. The performance of the varactor device can be further enhanced through the support structure. A portion of the semiconductor material of the support structure can be doped to facilitate transfer of charges between the opposing signals, which can further reduce the resistance and improve the Q factor of the varactor device.

Moreover, the varactor device can incorporate gate-all-around (GAA) transistor designs, which provides further advantages. A semiconductor region can have a nanoribbon-based architecture. For instance, the semiconductor region may include a plurality of nanoribbons that are stacked. Each nanoribbon may include a semiconductor material. The gate coupled to the semiconductor region can enclose the nanoribbons. With the GAA transistor design, the varactor device can have a smaller size, lower power consumption, and higher performance compared with varactor devices incorporating other types of transistor designs, such as planar FET (field effect transistor), FinFET, and so on. Given the advantages mentioned above or other advantages, the present disclosure provides more advantageous varactor designs than conventional technologies.

It should be noted that, in some settings, the term "nanoribbon" has been used to describe an elongated semiconductor structure that has a substantially rectangular transverse cross-section (e.g., a cross-section in a plane perpendicular to the longitudinal axis of the structure), while the term "nanowire" has been used to describe a similar structure but with a substantially circular or square transverse cross-sections. In the following, a single term "nanoribbon" is used to describe an elongated semiconductor structure independent of the shape of the transverse cross-section. Thus, as used herein, the term "nanoribbon" is used to cover elongated semiconductor structures that have substantially rectangular transverse cross-sections (possibly with rounded corners), elongated semiconductor structures that have substantially square transverse cross-sections (possibly with rounded corners), elongated semiconductor structures that have substantially circular or elliptical/oval transverse cross-sections, as well as elongated semiconductor structures that have any polygonal transverse cross-sections.

In the following, some descriptions may refer to a particular source or drain (S/D) region or contact being either a source region/contact or a drain region/contact. However, unless specified otherwise, which region/contact of a transistor or diode is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metal layer" may refer to a layer above a substrate that includes electrically conductive interconnect structures for providing electrical connectivity between different IC components. Metal layers described herein may also be referred to as "interconnect layers" to clearly indicate that these layers include electrically conductive interconnect structures which may, but do not have to be, metal.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 10%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 8% of a target value, e.g., within +/- 5% of a target value or within +/- 2% of a target value, based on the context of a particular value as described herein or as known in the art. Also, the term "or" refers to an inclusive "or" and not to an exclusive "or."

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

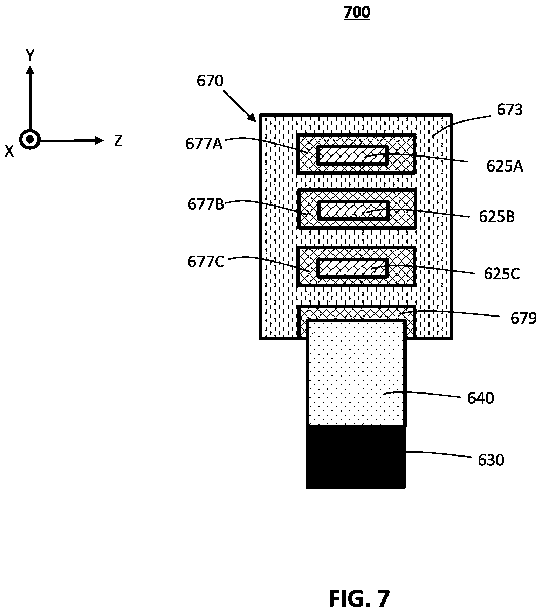

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For convenience, if a collection of drawings designated with different letters are present, e.g., FIGS. 7A-7B, such a collection may be referred to herein without the letters, e.g., as "FIG. 7."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of varactor devices with backside electrical contacts as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various varactor devices with backside electrical contacts as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

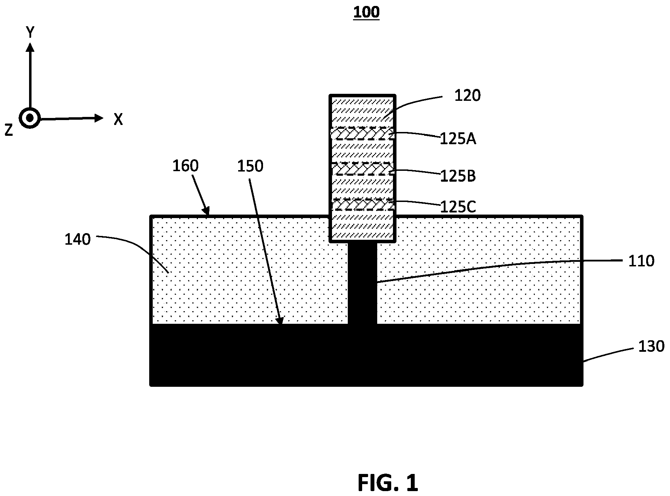

FIG. 1 illustrates an electrical contact structure 110 that couples a semiconductor structure 120 to a backside metal layer 130, according to some embodiments of the disclosure. FIG. 1 also shows a substrate 140 in which the electrical contact structure 110 is arranged. The substrate 140 includes two surfaces 150 and 160. The surface 150 opposes the surface 160. The side of the substrate 140 from the surface 150 downwards is referred to as the backside of the substrate 140, and the side of the substrate 140 from the surface 160 upwards is referred to as the frontside. The surface 150 is the referred to as backside surface, the surface 160 is referred to as the frontside surface. Various layers can be arranged in the frontside and backside of the substrate 140. In the embodiments of FIG. 1, the backside metal layer 130 is arrange at the backside of the substrate 140. Even though not shown in FIG. 1, one or more metal layers may be arranged at the frontside of the substrate 140.

The electrical contact structure 110 is inside the substrate 140 and is between the surfaces 150 and 160. The electrical contact structure 110 is an electrically conductive structure that provides an electrical connection between the semiconductor structure 120 and the backside metal layer 130. An end of the electrical contact structure 110 is connected to the semiconductor structure 120, and the opposing end of the electrical contact structure 110 is connected to the backside metal layer 130. In the embodiments of FIG. 1, the substrate 140 encloses the whole electrical contact structure 110. In other embodiments, the substrate 140 may enclose a portion of the electrical contact structure 110.

The semiconductor structure 120 is partially inside the substrate 140. A portion of the semiconductor structure 120 is outside the substrate 140 and is at the frontside of the substrate 140. The semiconductor structure 120 may be an epitaxial semiconductor structure that includes a crystalline structure of a semiconductor material. In some embodiments, the semiconductor structure 120 may be formed using an epitaxy process. For instance, a recess may be formed at the surface 160 of the substrate 140. An epitaxial deposition process may then be carried out to fill the recesses with one or more materials used to fabricate the semiconductor structure 120.

The semiconductor structure 120 may be formed around three elongated semiconductor structures 125A-125C (collectively referred to as "elongated semiconductor structures 125" or "elongated semiconductor structure 125"). Each elongated semiconductor structure 125 may be partially or wholly enclosed by the semiconductor structure 120. Even though FIG. 1 shows three elongated semiconductor structures 125, there can be a different number of elongated semiconductor structures 125 associated with the semiconductor structure 120. An elongated semiconductor structure 125 may be a non-planar structure, i.e., a three-dimensional structure, such as fin, nanoribbon, or nanowire. An elongated semiconductor structure 125 may have a longitudinal axis and a transvers cross-section perpendicular to the longitudinal axis. A dimension of the elongated semiconductor structure 125 along the longitudinal axis may be greater than dimensions along other directions, e.g., directions along axes perpendicular to the longitudinal axis. In the embodiments of FIG. 1, the elongated semiconductor structures 125 are nanoribbons having longitudinal axes along the X axis and transvers cross-sections in the Y-Z plane. The longitudinal axes of the elongated semiconductor structures 125 can be in parallel. With the orientation of the semiconductor structure 120 shown in FIG. 1, the elongated semiconductor structures 125 extends horizontally (i.e., along the X axis in FIG. 1) but stacked vertically (i.e., along the Y axis).

The semiconductor structure 120 and the elongated semiconductor structures 125 may include a same semiconductor material or different semiconductor materials. The semiconductor material in the semiconductor structure 120 may be a Group IV material, a compound of Group IV materials, a Group III/V material, a compound of Group III/V materials, a Group II/VI material, a compound of Group II/VI materials, or other semiconductor materials. Example Group II materials include zinc (Zn), cadmium (Cd), and so on. Example Group III materials include aluminum (Al), boron (B), indium (In), gallium (Ga), and so on. Example Group IV materials include silicon (Si), germanium (Ge), carbon (C), etc. Example Group V materials include nitrogen (N), phosphorus (P), arsenic (As), antimony (Sb), and so on. Example Group VI materials include sulfur (S), selenium (Se), tellurium (Te), oxygen (O), and so on. A compound of Group IV materials can be a binary compound, such as SiC, SiGe, and so on. A compound of Group III/V materials can be a binary, tertiary, or quaternary compound, such as GaN, InN, and so on. A compound of Group II/VI materials can be a binary, tertiary, or quaternary compounds, such as CdSe, CdS, CdTe, ZnO, ZnSe, ZnS, ZnTe, CdZnTe, CZT, HgCdTe, HgZnTe, and so on.

In some embodiments, the semiconductor structure 120 is doped. The dopants in the semiconductor structure 120 may be n-type dopants or p-type dopants. Example n-type dopants include Te, S, As, tin (Sn), Si, Ga, Se, S, In, Al, Cd, chlorine (CI), iodine (I), fluorine (F), and so on. Example p-type dopants include beryllium (Be), Zn, magnesium (Mg), Sn, P, Te, lithium (Li), sodium (Na), Ga, Cd, and so on. In some embodiments, the semiconductor structure 120 may be highly doped, e.g., with a dopant concentration of about 1×10²⁰ to 1×10²¹ dopants per cubic centimeter (cm⁻³) in order to form a terminal of a varactor device. The dopant concentration in the semiconductor structure 120 may be the dopant concentration of a semiconductor material in the semiconductor structure 120. In some embodiments, the dopant concentration is a concentration of n-type dopants. Irrespective of the exact doping levels, the semiconductor structure 120 may be the regions having dopant concentrations higher than in other regions, e.g., higher than a dopant concentration in an elongated semiconductor structure 125 and, therefore, may be referred to as highly doped regions. In some embodiments, a dopant concentration in the semiconductor structure 120 is 10 to 1000 times higher than a dopant concentration in an elongated semiconductor structure 125.

In some embodiments, the semiconductor material of an elongated semiconductor structure 125 may be an intrinsic (e.g., undoped) semiconductor material or alloy, not intentionally doped with any electrically active impurity. In alternate embodiments, nominal impurity dopant levels may be present in the elongated semiconductor structure 125. In such impurity-doped embodiments however, impurity dopant level within the elongated semiconductor structure 125 can be significantly lower than the dopant level in the semiconductor structure 120. For instance, the dopant concentration in the elongated semiconductor structure 125 may be in a range from 1×10¹⁸ to 1×10¹⁹ cm⁻³, which may be 10 to 1000 times lower than the dopant concentration in the semiconductor structure 120

The substrate 140 may be any suitable structure based on which the semiconductor structure 120 can be built, e.g., a die, a wafer, or a chip. Therefore, the substrate 140 may be referred to as a "support structure." In some embodiments, the substrate 140 may be a printed circuit board (PCB) substrate. In other embodiments, the substrate 140 is a semiconductor substrate, which is composed of semiconductor material systems including, for example, n-type or p-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of Group III-V, Group II-VI, or Group IV materials. In some embodiments, the substrate may be non-crystalline.

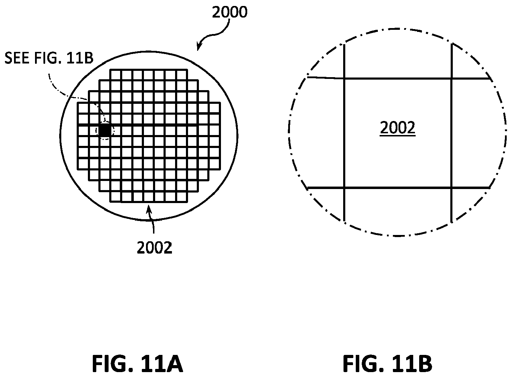

Although a few examples of materials from which the substrate 140 may be formed are described here, any material that may serve as a foundation upon which IC devices implementing varactor devices as described herein may be built falls within the spirit and scope of the present disclosure. In various embodiments, the substrate may include any such substrate material that provides a suitable surface for forming the fill pattern. The substrate may, e.g., be the wafer 2000 of FIG. 11A, discussed below, and may be, or be included in, a die, e.g., the singulated die 2002 of FIG. 11B, discussed below.

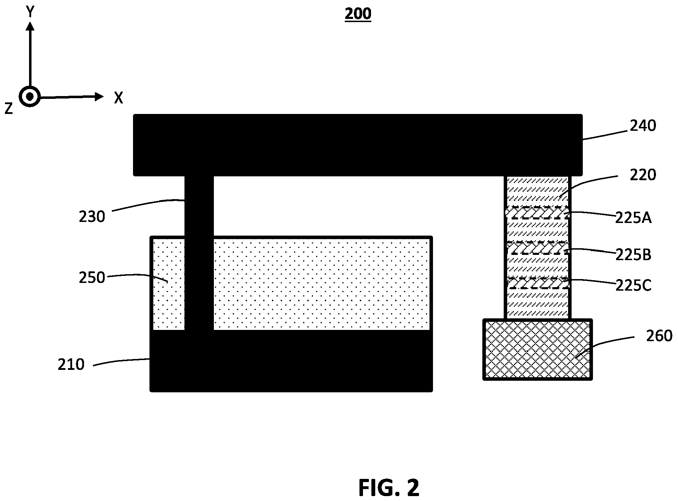

In some embodiments, the semiconductor structure 120 functions as a terminal of a varactor device. The backside metal layer 130 may be a ground plane. Through the electrical contact structure 110, the semiconductor structure 120 can be grounded. A dimension of the substrate 140 along the Y axis (i.e., a distance from the surface 150 to the surface 160) can be in a range from 50 nanometers to 70 nanometers and therefore, the dimension of the electrical contact structure 110 along the Y axis can be less than 50-70 nanometers. The electrical contact structure 110 provides an electrical connection route with a minimized distance between the semiconductor structure 120 and the backside metal layer 130.With the electrical connection route facilitated by the electrical contact structure 110, the varactor device can have better performance than conventional varactor devices, such as the one shown in FIG. 2.

FIG. 2 is a cross-sectional view of a varactor device 200 without backside electrical contact, according to some embodiments of the disclosure. The varactor device 200 includes a backside metal layer 210, a semiconductor structure 220, elongated semiconductor structures 225A-225C, a feedthrough via 230, a trench contact 240, a substrate 250, and an electrical insulator 260. In other embodiments, the varactor device 200 may include fewer, more, or different components. The backside metal layer 210 may be the same or similar as the backside metal layer 130. The semiconductor structure 220 may be the same or similar as the semiconductor structure 120. The semiconductor structure 220 is a terminal of the varactor device 200. The elongated semiconductor structures 225A-225C may be the same or similar as the elongated semiconductor structures 125. The substrate 250 may be the same or similar as the substrate 140.

However, different from the electrical connection route in FIG. 1, the semiconductor structure 220 is coupled to the backside metal layer 210 through an electrical connection route that includes the feedthrough via 230 and the trench contact 240. Even if the dimension of the substrate 250 along the Y axis is similar to the corresponding dimension of the substrate 140, the electrical connection route in FIG. 2 can still be significantly longer than the electrical connection route in FIG. 1. With a longer electrical connection route, the parasitic resistance of the varactor device 200 would be higher, which undermines the Q factor of the varactor device 200. Also, the trench contact 240 may form additional capacitance, e.g., with another terminal of the varactor device 200. The additional capacitance can increase the minimum capacitance of the varactor device 200 and thereby reducing the capacitance ratio of the varactor device 200. Therefore, compared with the varactor device 200, varactor devices with the electrical contact structure 110 in FIG. 1 can have better Q factor and better capacitance ratio, i.e., better performance.

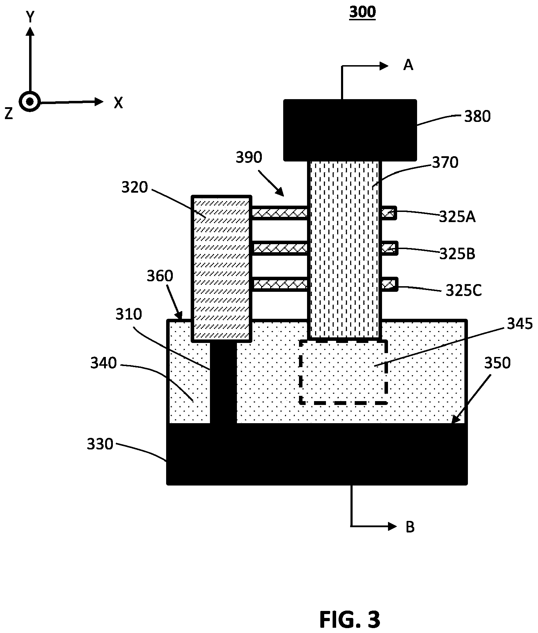

FIG. 3 is a cross-sectional view of a two-terminal varactor device 300 with backside electrical contact, according to some embodiments of the disclosure. The varactor device 300 includes a contact structure 310, a semiconductor structure 320, elongated semiconductor structures 325A-325C (collectively referred to as "elongated semiconductor structures 325" or "elongated semiconductor structure 325"), an electrically conductive layer 330, a substrate 340, a gate 370, and another electrically conductive layer 380. The electrically conductive layers 330 and 380 constitute the two terminals of the varactor device 300 and can provide two different signals. In other embodiments, the varactor device 300 may include fewer, more, or different components.

The contact structure 310 includes an electrically conductive material, such as metal. The contact structure 310 is inside the substrate 340. The substrate 340 includes two surfaces 350 and 360. The surface 350 opposes the surface 360. The side of the substrate 340 from the surface 350 downwards is referred to as the backside of the substrate 340, and the side of the substrate 340 from the surface 360 upwards is referred to as the frontside. The surface 350 is the referred to as backside surface, the surface 360 is referred to as the frontside surface. Various layers can be arranged in the frontside and backside of the substrate 340. In the embodiments of FIG. 3, the electrically conductive layer 330 is arrange at the backside of the substrate 340, and the electrically conductive layer 380 arranged at the frontside of the substrate 340. The substrate 340 may be an embodiment of the substrate 140 in FIG. 1.

The semiconductor structure 320 includes a doped semiconductor material, such as one of the semiconductor materials described above. The semiconductor structure 320 may be doped with n-type dopants. A concentration of dopants in the semiconductor structure 320 can be in a range from 1×10²⁰ to 1×10²¹ cm⁻³. The semiconductor structure 320 may be an epitaxial structure that includes a crystalline structure of the semiconductor material. The semiconductor structure 320 may be an embodiment of the semiconductor structure 120 in FIG. 1. As shown in FIG. 3, an end of the semiconductor structure 320 (i.e., the end in the substrate 340 in FIG. 3) is connected to an end of the contact structure 310 (i.e., the end that is closer to the surface 360 than the surface 350). The other end of the contact structure 310 is at the surface 350 and is connected to the electrically conductive layer 330. In some embodiments, the electrically conductive layer 330 is a ground plane, and the semiconductor structure 320 can be grounded.

The semiconductor structure 320 is connected to the elongated semiconductor structures 325. In some embodiments, the semiconductor structure 320 is formed around a portion of each of the elongated semiconductor structures 325, such as a portion that is enclosed by the semiconductor structure 320. The portion of the elongated semiconductor structure 325 may be highly doped. For instance, the concentration of dopants in the portion of the elongated semiconductor structure 325 may be the same or similar as the concentration of dopants in the semiconductor structure 320. The portion of the elongated semiconductor structure 325 may be doped with the same type of dopants as the semiconductor structure 320. In alternative embodiments, the semiconductor structure 320 is formed adjacent to the elongated semiconductor structures 325.

The elongated semiconductor structures 325 are non-planar semiconductor structures, such as nanoribbons. The elongated semiconductor structures 325 can be arranged in parallel. For instance, longitudinal axes of the elongated semiconductor structures 325 can be in parallel, e.g., along the X axis. At least a portion of each elongated semiconductor structures 325, such as the portion wrapped around by the gate 370, may be undoped or lowly doped. In some embodiments, A concentration of dopants in the elongated semiconductor structures 325 can be in a range from 1×10¹⁸ to 1×10¹⁹ cm⁻³. Some or all of the elongated semiconductor structures 325 can either be inverted or accumulated, depending on the doping type in the elongated semiconductor structures 525. An elongated semiconductor structure 325 may be an embodiment of an elongated semiconductor structure 125 in FIG. 1.

In the embodiments of FIG. 3, the elongated semiconductor structures 325 are coupled to a gate 370. The gate is around a portion of each of the elongated semiconductor structures 325. The gate 370 is coupled to the electrically conductive layer 380. The electrically conductive layer 380 may be a power plane or signal power that can provide electrical power or signal to the gate 370. As the semiconductor structure 320 is grounded and the gate 370 is polarized, there can be an electrical potential between the semiconductor structure 320 and the gate 370. Also, a region 390 between the semiconductor structure 320 and the gate 370 can be an electrically insulating region, e.g., a depletion region. Thus, the semiconductor structure 320, the gate 370, and the region 390 can constitute a variable capacitor. The region 390 may include a portion of each of the elongated semiconductor structures 325. In some embodiments, the region 390 may include an electrical insulator surrounding the portions of the elongated semiconductor structures 325.

In some embodiments, a portion 345 of the substrate 340, which is under the gate 370, may be doped with an opposing type of dopants from the semiconductor structure 320. As the portion 345 of the substrate 340 and the semiconductor structure 320 is counter doped, parasitic conduction path through the substrate 340 can be avoided. Additionally or alternatively, one or more of the elongated semiconductor structures 325 are doped, e.g., with the same type of dopants as the semiconductor structure 320. The varactor device 300 may operate either as an accumulation mode device or as an inversion mode device.

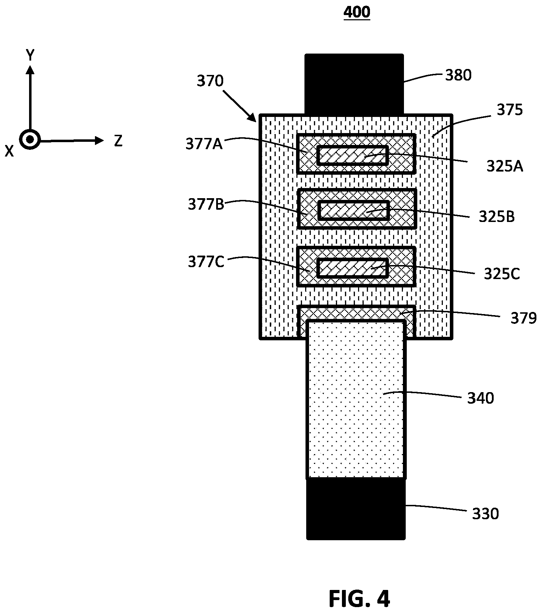

FIG. 4 is another cross-sectional view of the two-terminal varactor device 300 in FIG. 3, according to some embodiments of the disclosure. FIG. 4 shows a cross-section 400 of the varactor device 300 in the A-B plane shown in FIG. 3. As shown in FIG. 4, the gate 370 includes gate insulators 377A-377C and 379 and a gate electrode 375. A gate insulator includes an electrical insulator, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc. Each of the gate insulators 377A-377C encloses a different elongated semiconductor structure 325 to insulate the elongated semiconductor structure 325 from the gate electrode 375. The gate insulator 379 surrounds a portion of the substrate 340 to insulate the substrate 340 from the gate electrode 375. The gate insulator 379 is closer to the surface 360 than the surface 350 of the substrate 340. The gate electrode 375 includes an electrically conductive material, e.g., metal. The gate electrode 375 is coupled to the electrically conductive layer 380.

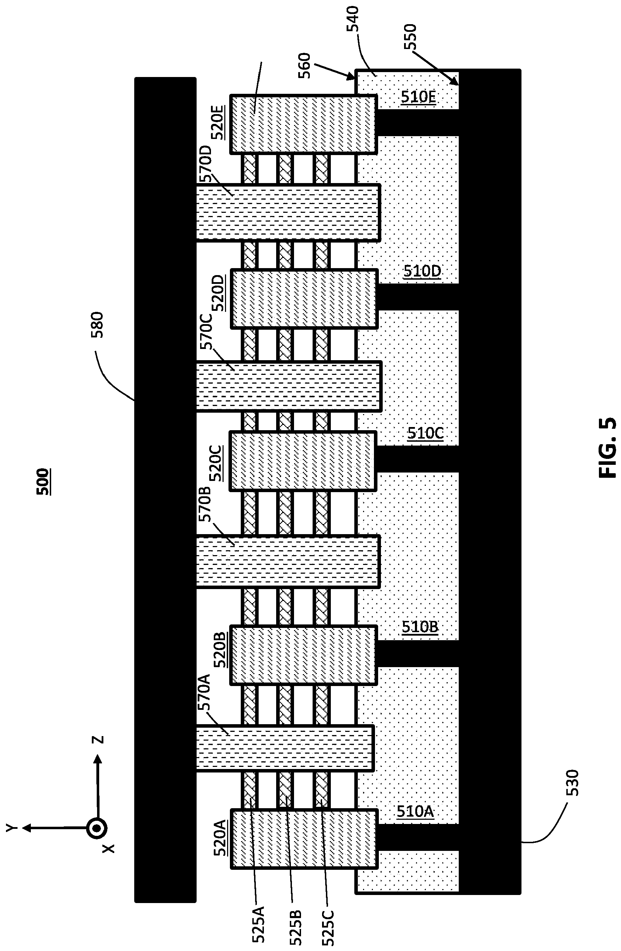

FIG. 5 is a cross-sectional view of another two-terminal varactor device 500 with backside electrical contact, according to some embodiments of the disclosure. The varactor device 500 includes five contact structures 510A-510E (collectively referred to as "contact structures 510" or "contact structure 510"), five semiconductor structures 520A-520E (collectively referred to as "semiconductor structures 520" or "semiconductor structure 520"), three elongated semiconductor structures 525A-325C (collectively referred to as "elongated semiconductor structures 525" or "elongated semiconductor structure 525"), an electrically conductive layer 530, a substrate 540, four gates 570A-570D (collectively referred to as "gates 570" or "gate 570"), and another electrically conductive layer 580. The electrically conductive layers 530 and 580 constitute the two terminals of the varactor device 500. In other embodiments, the varactor device 500 may include fewer, more, or different components, such as a different number of contact structure, semiconductor structures, elongated semiconductor structures, gates, or electrically conductive layers.

Each contact structure 510 includes an electrically conductive material, such as metal. Each contact structure 510 is inside the substrate 540 and extends between two surfaces 550 and 560 of the substrate 540. The surface 550 opposes the surface 560. The side of the substrate 540 from the surface 550 downwards is referred to as the backside of the substrate 540, and the side of the substrate 540 from the surface 560 upwards is referred to as the frontside. The surface 550 is the referred to as backside surface, the surface 560 is referred to as the frontside surface. Various layers can be arranged in the frontside and backside of the substrate 540. In the embodiments of FIG. 5, the electrically conductive layer 530 is arrange at the backside of the substrate 540, and the electrically conductive layer 580 arranged at the frontside of the substrate 540. The substrate 540 may be an embodiment of the substrate 140 in FIG. 1.

Each contact structure 510 is paired with a different semiconductor structure 520 and couples the semiconductor structure 520 to the electrically conductive layer 530. Each semiconductor structure 520 includes a doped semiconductor material, such as one of the semiconductor materials described above. A concentration of dopants in the semiconductor structure 520 can be in a range from 1×10²⁰ to 1×10²¹ cm⁻³.The semiconductor structure 520 may be an epitaxial structure that includes a crystalline structure of the semiconductor material. The semiconductor structure 520 may be an embodiment of the semiconductor structure 120 in FIG. 1. As shown in FIG. 5, an end of a semiconductor structure 520 (i.e., the end in the substrate 540 in FIG. 5) is connected to an end of the corresponding contact structure 510 (i.e., the end that is closer to the surface 560 than the surface 550). The other end of the contact structure 510 is at the surface 550 and is connected to the electrically conductive layer 530. In some embodiments, the electrically conductive layer 530 is a ground plane, and the semiconductor structure 520 can be grounded.

Each semiconductor structure 520 is connected to the elongated semiconductor structures 525. In some embodiments, an elongated semiconductor structure 525 is a continuous structure that extends between the semiconductor structure 520A and the semiconductor structure 520E. In other embodiments, an elongated semiconductor structure 525 may include a plurality of discrete portions, each of which is between two adjacent semiconductor structures 520, such as a first portion between the semiconductor structure 520A and the semiconductor structure 520B, a second portion between the semiconductor structure 520B and the semiconductor structure 520C, a third portion between the semiconductor structure 520C and the semiconductor structure 520D, and a fourth portion between the semiconductor structure 520D and the semiconductor structure 520E.

In some embodiments, the semiconductor structure 520 is formed around a portion of each of the elongated semiconductor structures 525, such as a portion that is enclosed by the semiconductor structure 520. In alternative embodiments, the semiconductor structure 520 is formed adjacent to the elongated semiconductor structures 525. The elongated semiconductor structures 525 are non-planar semiconductor structures, such as nanoribbons. The elongated semiconductor structures 525 may be undoped or lowly doped. In some embodiments, A concentration of dopants in the elongated semiconductor structures 525 can be in a range from 1×10¹⁸ to 1×10¹⁹ cm⁻³. An elongated semiconductor structure 525 may be an embodiment of an elongated semiconductor structure 125 in FIG. 1.

In the embodiments of FIG. 5, the elongated semiconductor structures 525 are coupled to the four gates 570. Each gate 570 is around a portion of each of the elongated semiconductor structures 525. The gates 570 are coupled to the electrically conductive layer 580. The electrically conductive layer 580 may be a power plane or signal power that can provide electrical power or signal to the gate 570. As the semiconductor structures 520 are grounded and the gates 570 are polarized, there can be an electrical potential between a semiconductor structure 520 and the gate 570 that is adjacent to the semiconductor structure 520. Also, the region between the semiconductor structure 520 and the corresponding gate 570 can be an electrically insulating region, e.g., a depletion region. In some embodiments, an elongated semiconductor structure 525 (or all the elongated semiconductor structures 525) can be encapsulated by an electrical insulator of the gate 570. The elongated semiconductor structure 525 can either be inverted or accumulated, depending on the doping type in the elongated semiconductor structure 525. The semiconductor structure 520, the gate 570, and the region can constitute a variable capacitor. The varactor device 500 includes a series of variable capacitors.

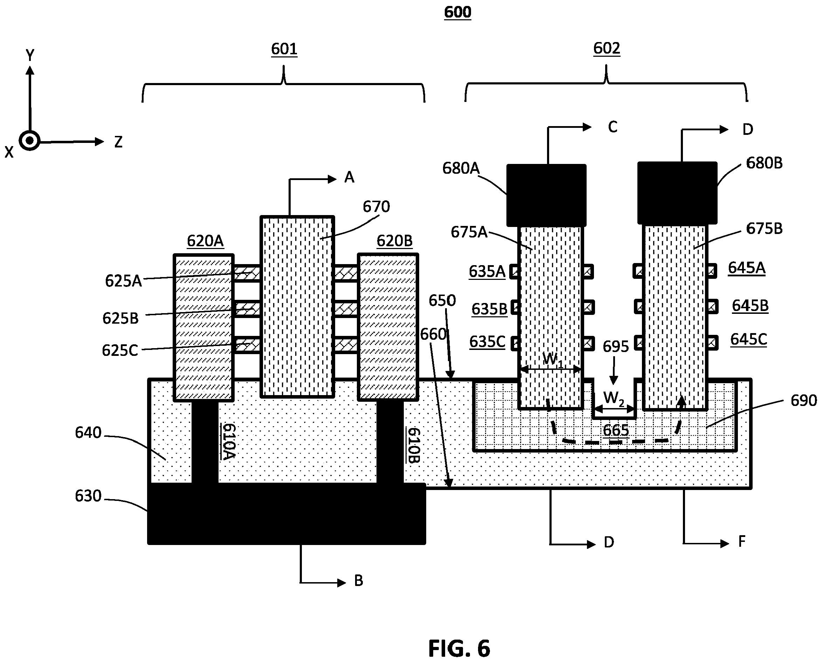

FIG. 6 is a cross-sectional view of a three-terminal varactor device 600 with backside electrical contact, according to some embodiments of the disclosure. The varactor device 600 includes two sections 601 and 602 that share a substrate 640, which may be an embodiment of the substrate 140 in FIG. 1. The section 601 includes contact structures 610A and 610B (collectively referred to as "contact structures 610" or "contact structure 610"), semiconductor structures 620A and 620B (collectively referred to as "semiconductor structures 620" or "semiconductor structure 620"), elongated semiconductor structures 625A-625C (collectively referred to as "elongated semiconductor structures 625" or "elongated semiconductor structure 625"), an electrically conductive layer 630, a gates 670, and another electrically conductive layer 675.

The section 602 includes elongated semiconductor structures 635A-635C (collectively referred to as "elongated semiconductor structures 635" or "elongated semiconductor structure 635"), elongated semiconductor structures 645A-645C (collectively referred to as "elongated semiconductor structures 645" or "elongated semiconductor structure 645"), gates 680A and 680B, and electrically conductive layers 680A and 680B. In other embodiments, the varactor device 600 may include fewer, more, or different components. The electrically conductive layers 630, 680A, and 680B constitute the three terminals of the varactor device 600. In some embodiments, the electrically conductive layer 630 is a ground plane, and the electrically conductive layers 680A and 680B are signal planes that can provide signals of opposite polarity.

The substrate 640 includes surfaces 650 and 660. The surface 650 opposes the surface 660. The side of the substrate 640 from the surface 650 downwards is referred to as the backside of the substrate 640, and the side of the substrate 640 from the surface 660 upwards is referred to as the frontside. The surface 650 is the referred to as backside surface, the surface 660 is referred to as the frontside surface. Various layers can be arranged in the frontside and backside of the substrate 640. In the embodiments of FIG. 6, the electrically conductive layer 630 is arrange at the backside of the substrate 640, and the electrically conductive layers 680A and 680B are arranged at the frontside of the substrate 640. The substrate 640 may be an embodiment of the substrate 140 in FIG. 1.

The section 601 may be a tap structure of the varactor device 600. The section 601 may be used as a virtual ground biased at a DC voltage for determining the differential capacitance between the two gates 675A and 675B. In the section 601, the electrically conductive layer 630 is at the backside of the substrate 640. The contact structure 610A couples the semiconductor structure 620A to the electrically conductive layer 630. The contact structure 610B couples the semiconductor structure 620B to the electrically conductive layer 630. Each of the elongated semiconductor structures 625 extend from the semiconductor structure 620A to the semiconductor structure 620B. A portion of each elongated semiconductor structure 625 is wrapped around by the gate 670. The elongated semiconductor structures 625 can be arranged in parallel. For instance, longitudinal axes of the elongated semiconductor structures 625 can be in parallel, e.g., along the X axis.

Each contact structure 610 may be an embodiment of the electrical contact structure 110 in FIG. 1 or the contact structure 310 in FIG. 3. Each semiconductor structure 620 may be an embodiment of the semiconductor structure 120 in FIG. 1 or the semiconductor structure 320 in FIG. 3. Each elongated semiconductor structure 625 may be an embodiment of the elongated semiconductor structure 125 in FIG. 1 or the elongated semiconductor structure 325 in FIG. 3. The electrically conductive layer 630 may be an embodiment of the backside metal layer 130 in FIG. 1 or the electrically conductive layer 330 in FIG. 3. The gate 670 may be an embodiment of the gate 370 in FIG. 3.

In the section 602, the gates 675A and 675B can be polarized. In some embodiments, the gates 675A and 675B have differential polarity. For example, the gates 675A and 675B may have the same type of polarity (e.g., positive or negative polarity), but the gate 675A is set to a high polarity and the gate 675B is set to low polarity, or the gate 675B is set to high polarity and the gate 675A is set to low polarity. As another example, the gates 675A and 675B may have different types of polarity, e.g., the gate 675A is set to positive polarity and the gate 675B is set to negative polarity, or the gate 675B is set to positive polarity and the gate 675A is set to negative polarity.

The gate 675A is coupled to the elongated semiconductor structures 635 and wraps around a portion of each elongated semiconductor structure 635. The gate 675B is coupled to the elongated semiconductor structures 645 and wraps around a portion of each elongated semiconductor structure 645. The elongated semiconductor structures 635 and 645 may be undoped or lowly doped. In some embodiments, the elongated semiconductor structures 635 and 645 may function as channel regions coupled to the gates 675A and 675B, respectively. The gate 675A is coupled to the electrically conductive layer 680A, and the gate 675A is coupled to the electrically conductive layer 680B. The electrically conductive layers 680A and 680B may be two power planes or signals planes and can provide different electrical signals. The electrically conductive layers 680A and 680B may be separated by one or more electrical insulators. Also, the gates 675A and 675B may be separated by one or more electrical insulators.

Electrical charges can be transferred between the gate 675A and the gate 675B, or the other way around, through a charge conduction path 665 in a portion 690 of the substrate 640. In FIG. 6, the charge conduction path 665 is from the gate 675A to the gate 675B. In alternative embodiments, the charge conduction path 665 is from the gate 675B to the gate 675A. The portion 690 is over (e.g., underneath) the gates 675A and 675B. The portion 690 may be doped to reduce resistance and increase the Q factor of the varactor device 600. In some embodiments, a concentration of dopants in the portion 690 is higher than a concentration of dopants in the rest of the substrate 640, such as two to three times higher. The concentration of dopants in the portion 690 may be in a range from 1×10¹⁸ to 1×10¹⁸ cm⁻³.

An opening 695 between the two gates 675A and 675B is formed in the portion 690. The opening 695 is at the surface 660. As shown in FIG. 6, the gate 675A has a width W₁ along the Z axis. Even though not shown in FIG. 6, the gate 675B may also have the width W₁. The opening 695 has a width W₂ along the Z axis. The width W₁ may be in a range from 12-20 nanometers The width W₂ may be in a range from 30-50 nanometers. The greater the width W₁, the large charge accumulation on the gate 675A, the larger the maximum capacitance of the varactor device 600, and the larger the capacitance ratio of the varactor device 600. The lower the width W₂, the shorter the charge conduction path 665, the smaller the resistance of the varactor device 600, and the larger the Q factor of the varactor device 600. In some embodiments, the gates 675A and 675B or the opening 695 may be formed by EUV patterning to form wider gates and narrower opening to achieve optimal performance of the varactor device 600.

FIG. 7 is another cross-sectional view of the three-terminal varactor device in FIG. 6, according to some embodiments of the disclosure. FIG. 7 shows a cross-section 700 of the varactor device 600 in the A-B plane shown in FIG. 6. As shown in FIG. 7, the gate 670 includes gate insulators 677A-677C and 679 and a gate electrode 673. Each of the gate insulators 677A-377C encloses a different elongated semiconductor structure 625 to insulate the elongated semiconductor structure 625 from the gate electrode 673. The gate insulator 679 surrounds a portion of the substrate 640 to insulate the substrate 640 from the gate electrode 673. The gate insulator 679 is closer to the surface 660 than the surface 650 of the substrate 640. The gate electrode 673 includes an electrically conductive material, e.g., metal.

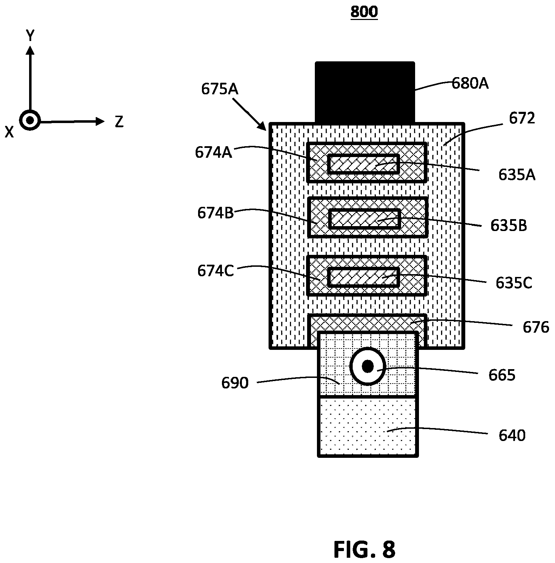

FIG. 8 is yet another cross-sectional view of the three-terminal varactor device in FIG. 6, according to some embodiments of the disclosure. FIG. 8 shows a cross-section 800 of the varactor device 600 in the C-D plane shown in FIG. 6. As shown in FIG. 8, the gate 675A includes a gate electrode 672 and gate insulators 674A-674C and 676. Each of the gate insulators 674A-674C encloses a different elongated semiconductor structure 635 to insulate the elongated semiconductor structure 635 from the gate electrode 672. The gate insulator 676 surrounds a part of the portion 690 of the substrate 640 to insulate the portion 690 of the substrate 640 from the gate electrode 672. The charge conduction path 665 comes out from the C-D plane, which is shown as the circle dot in FIG. 8.

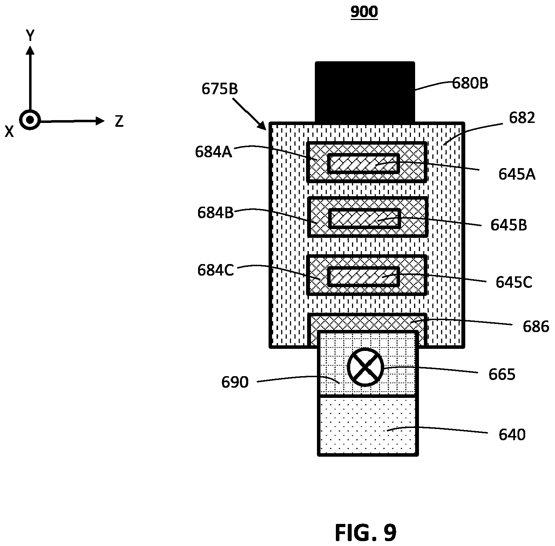

FIG. 9 is yet another cross-sectional view of the three-terminal varactor device in FIG. 6, according to some embodiments of the disclosure. FIG. 9 shows a cross-section 900 of the varactor device 600 in the E-F plane shown in FIG. 6. As shown in FIG. 9, the gate 675B includes a gate electrode 682 and gate insulators 684A-684C and 686. Each of the gate insulators 684A-684C encloses a different elongated semiconductor structure 645 to insulate the elongated semiconductor structure 645 from the gate electrode 682. The gate insulator 686 surrounds a part of the portion 690 of the substrate 640 to insulate the portion 690 of the substrate 640 from the gate electrode 682. The charge conduction path 665 comes into the E-F plane, which is shown as the circled cross in FIG. 9.

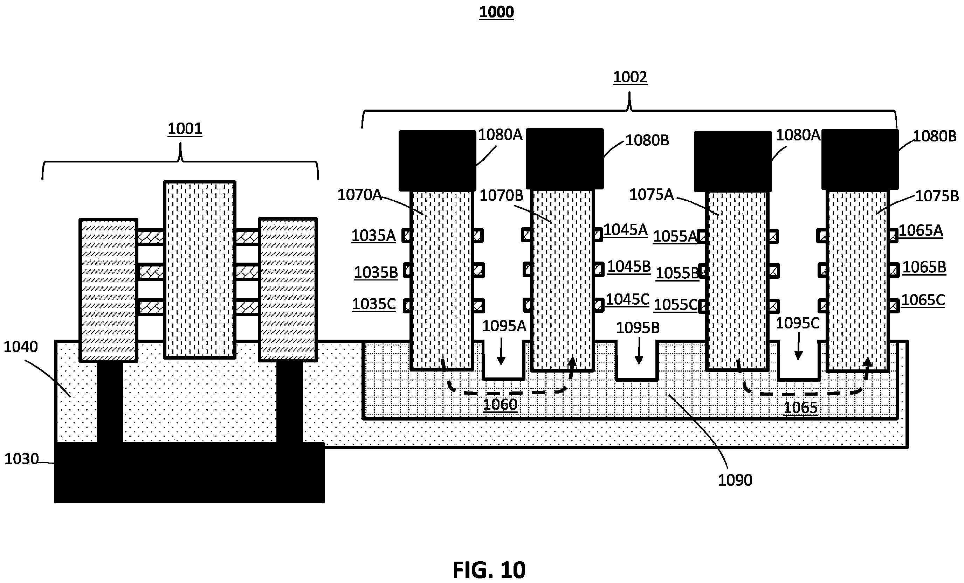

FIG. 10 is a cross-sectional view of another three-terminal varactor device 1000 with backside electrical contact, according to some embodiments of the disclosure. The three terminals of the varactor device 1000 are electrically conductive layers 1030, 1080A, and 1080B. The electrically conductive layer 1030 is arranged at the frontside of a substrate 1040, versus the electrically conductive layers 1080A and 1080B are arranged at the backside of the substrate 1040. The electrically conductive layers 1080A and 1080B are not continuous. Each of the electrically conductive layers 1080A and 1080B includes discrete sections that may receive the same signal and have the same polarity. The polarity of the electrically conductive layers 1080A may be opposite to the polarity of the electrically conductive layers 1080B.

The varactor device 1000 includes two sections 1001 and 1002. The section 1001 may be a tap structure of the varactor device 1000. The section 1001 is the same or similar as the section 601 in FIG. 6. Different from FIG. 6, the section 1002 in FIG. 10 includes two pairs of oppositely polarized gates: four gates 1070A, 1070B, 1075A, and 1075B. In other embodiments, the section 1002 may include more pairs of oppositely polarized gates. As shown in FIG. 10, the gates 1070A and 1075A are coupled to different sections of the electrically conductive layer 1080A. The gates 1070B and 1075B are coupled to different sections of the electrically conductive layer 1080B. The gate 1070A may have an opposite polarity from the gate 1070B, and the gate 1075A may have an opposite polarity from the gate 1075B.

A charge conduction path 1060 from the gate 1070A to the gate 1070B and another charge conduction path 1065 from the gate 1075A to the gate 1075B are present in a portion 1090 of the substrate 1040. The portion 1090 may be highly doped, e.g., with the same type of dopants as semiconductor structures in the section 1001. The charge conduction paths 1060 is from the gate 1070A to the gate 1070B. Adjacent gates of the four gates 1070A, 1070B, 1075A, and 1075B are separated from each other through openings 1095A-1095C formed in the portion 1090. For instance, the opening 1095A is between the gate 1080A and the gate 1080B, particularly between the portion of the gate 1080A in the portion 1090 and the portion of the gate 1080A in the portion 1090. In some embodiments, the gates 1070A, 1070B, 1075A, and 1075B or the opening 1095A-1095C may be formed by EUV patterning to form wider gates or narrower opening to achieve optimal performance of the varactor device 1000.

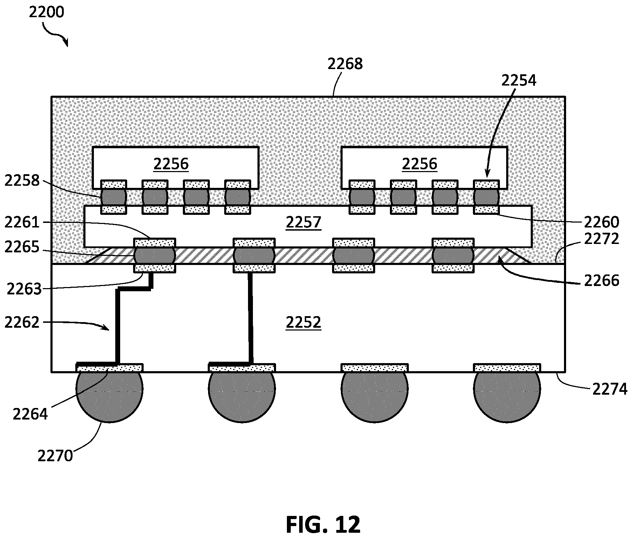

FIGS. 11A-11B are top views of a wafer 2000 and dies 2002 that may include one or more varactor devices with backside electrical contact, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 12. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs including one or more varactor devices as described herein). After the fabrication of the semiconductor product is complete (e.g., after manufacture of one or more varactor devices as described herein), the wafer 2000 may undergo a singulation process in which each of the dies 2002 is separated from one another to provide discrete "chips" of the semiconductor product. In particular, devices that include one or more varactor devices as disclosed herein may take the form of the wafer 2000 (e.g., not singulated) or the form of the die 2002 (e.g., singulated). The die 2002 may include one or more diodes (e.g., one or more varactor devices as described herein), one or more transistors (e.g., one or more III-N transistors as described herein) as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, an RF FE device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 12 is a side, cross-sectional view of an example IC package 2200 that may include one or more IC devices having varactor devices with backside electrical contact, according to some embodiments of the disclosure. In some embodiments, the IC package 2200 may be a system-in-package (SiP).

As shown in FIG. 12, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 12 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 12 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

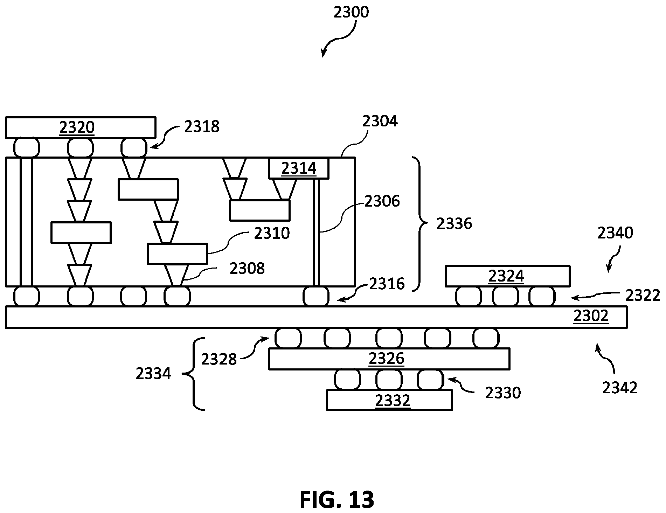

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 12 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 13.

The dies 2256 may take the form of any of the embodiments of the die 2002 discussed herein and may include any of the embodiments of an IC device having one or more varactor devices. In embodiments in which the IC package 2200 includes multiple dies 2256, the IC package 2200 may be referred to as a multi-chip package. Importantly, even in such embodiments of an MCP implementation of the IC package 2200, one or more varactor devices may be provided in a single chip, in accordance with any of the embodiments described herein. The dies 2256 may include circuitry to perform any desired functionality. For example, one or more of the dies 2256 may be ESD protection dies, including one or more varactor devices as described herein, one or more of the dies 2256 may be logic dies (e.g., silicon-based dies), one or more of the dies 2256 may be memory dies (e.g., high bandwidth memory), etc. In some embodiments, any of the dies 2256 may include one or more varactor devices, e.g., as discussed above; in some embodiments, at least some of the dies 2256 may not include any III-N diodes with n-doped wells and capping layers.

The IC package 2200 illustrated in FIG. 12 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 12, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 13 is a cross-sectional side view of an IC device assembly 2300 that may include components having one or more IC devices implementing varactor devices with backside electrical contact, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing one or more varactor devices in accordance with any of the embodiments disclosed herein; e.g., any of the IC packages discussed below with reference to the IC device assembly 2300 may take the form of any of the embodiments of the IC package 2200 discussed above with reference to FIG. 12 (e.g., may include one or more varactor devices in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 13 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 13), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 11B), an IC device (e.g., the IC device of FIGS. 1-2), or any other suitable component. In particular, the IC package 2320 may include one or more varactor devices as described herein. Although a single IC package 2320 is shown in FIG. 13, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 13, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. In some embodiments, the IC devices implementing one or more varactor devices as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 13 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

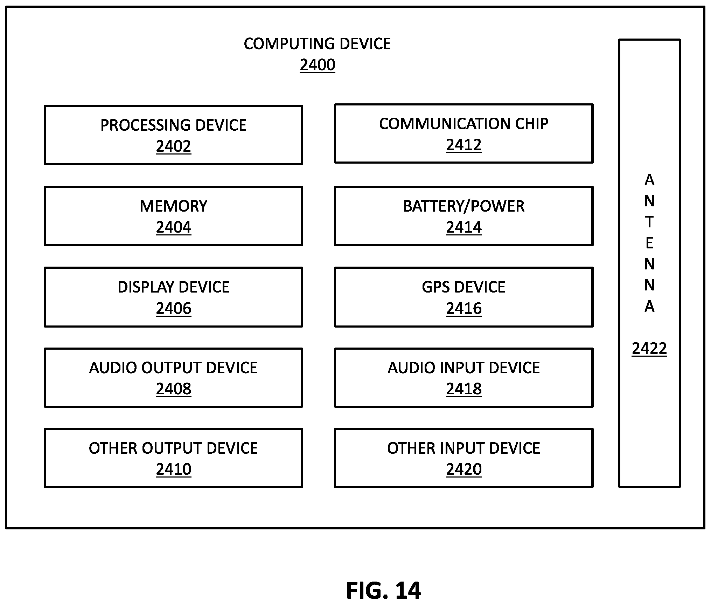

FIG. 14 is a block diagram of an example computing device 2400 that may include one or more components with one or more IC devices having one or more varactor devices, according to some embodiments of the disclosure. For example, any suitable ones of the components of the computing device 2400 may include a die (e.g., the die 2002 of FIG. 11B) including one or more varactor devices, according to some embodiments of the disclosure. Any of the components of the computing device 2400 may include a varactor device (e.g., any embodiment of the varactors devices of FIGS. 1 and 2-10) and/or an IC package (e.g., the IC package 2200 of FIG. 12). Any of the components of the computing device 2400 may include an IC device assembly (e.g., the IC device assembly 2300 of FIG. 13).

A number of components are illustrated in FIG. 14 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 14, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices having one or more varactor devices as described herein may be particularly advantageous for use as part of ESD circuits protecting power amplifiers, low-noise amplifiers, filters (including arrays of filters and filter banks), switches, or other active components. In some embodiments, IC devices having one or more varactor devices as described herein may be used in PMICs, e.g., as a rectifying diode for large currents. In some embodiments, IC devices having one or more varactor devices as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device. The IC device includes: a substrate having a first surface and a second surface, the second surface opposite the first surface; a layer comprising an electrically conductive material, wherein the layer is outside the substrate and is closer to the first surface than the second surface; a structure comprising a semiconductor material having a dopant concentration of at least 10¹⁸ cm⁻³, wherein at least a portion of the structure is closer to the second surface than to the first surface; a semiconductor region, at least of portion of which is closer to the second surface than to the first surface; and a contact structure at least partially enclosed by the substrate, wherein the contact structure comprises an electrically conductive material, a first end of the contact structure is connected to the layer, and a second end of the contact structure is connected to the structure.

Example 2 provides the IC device according to example 1, where the semiconductor region includes a plurality of semiconductor structures that are in parallel.

Example 3 provides the IC device according to any of the preceding examples, where: the layer is a first layer, the IC device further includes a second layer including another electrically conductive material, and the second layer is coupled to the semiconductor region.

Example 4 provides the IC device according to example 3, where the second layer is outside the substrate and is closer to the second surface than the first surface.

Example 5 provides the IC device according to example 3 or 4, further including a gate coupled to the second layer and to the semiconductor region.

Example 6 provides the IC device according to any of the preceding examples, where a distance from the first surface to the second surface is in a range from 50 nanometers to 70 nanometers.

Example 7 provides the IC device according to any of the preceding examples, where: the semiconductor material is a first semiconductor material, the semiconductor region comprises a second semiconductor material, and a dopant concentration of the second semiconductor material is 10 to 1000 times lower than the dopant concentration of the semiconductor material.

Example 8 provides the IC device according to any of the preceding examples, where the dopant concentration of the semiconductor material is a concentration of n-type dopants in the semiconductor material.

Example 9 provides the IC device according to any of the preceding examples, where the IC device is a varactor device.

Example 10 provides the IC device according to any of the preceding examples. The IC device further includes: an additional structure comprising an additional semiconductor material having a dopant concentration of at least 10¹⁸ cm⁻³, wherein at least a portion of the additional structure is closer to the second surface than to the first surface; and an additional contact structure at least partially enclosed by the substrate, wherein a first end of the additional contact structure is connected to the layer, and a second end of the additional contact structure is connected to the additional structure, wherein the semiconductor region is between the structure and the additional structure.

Example 11 provides a varactor device. The varactor device includes: a plurality of semiconductor structures, an individual semiconductor structure including a doped semiconductor material; a plurality of contact structures, an individual contact structure including an electrically conductive material and being between a first electrically conductive layer and an individual semiconductor structure of the plurality of semiconductor structures; and a plurality of semiconductor regions coupled to a second electrically conductive layer, where an individual channel region is between two semiconductor structures of the plurality of semiconductor structures in a first direction, and the individual channel region is between the first electrically conductive layer and the second electrically conductive layer in a second direction.

Example 12 provides the varactor device according to example 11. The varactor device further includes: a substrate between the first electrically conductive layer and the second electrically conductive layer, where at least a portion of the individual contact structure is enclosed in the substrate.

Example 13 provides the varactor device according to example 11 or 12, where the first electrically conductive layer is a ground plane.

Example 14 provides the varactor device according to any one of examples 11-13, where the individual contact structure includes a metal.

Example 15 provides the varactor device according to any one of examples 11-14, where an individual semiconductor region includes a plurality of semiconductor ribbons.

Example 16 provides an IC device. The IC device includes: a first section including: a first layer including a first electrically conductive material, a second layer including a second electrically conductive material, a first semiconductor region including a first semiconductor material and coupled to the first layer, and a second semiconductor region including a second semiconductor material and coupled to the second layer, where the first semiconductor region is separated from the second semiconductor region; and a second section including: a third layer including a third electrically conductive material, a structure including a doped semiconductor material, and a contact structure including an electrically conductive material and being between the first layer and the structure.

Example 17 provides the IC device according to example 16, further including: a substrate coupled to the first section and the second section, where the substrate is between the first layer and the third layer.

Example 18 provides the IC device according to example 17, where: the substrate includes a first region and a second region, the first region includes a third semiconductor material with a type of dopant, the second region includes a fourth semiconductor material with the type of dopant, and a dopant concentration in the first region is two to three times greater than a dopant concentration in the second region.

Example 19 provides the IC device according to example 18, further including: a first gate coupled to the first semiconductor region; and a second gate coupled to the second semiconductor region, where the first region encloses a portion of the first gate and encloses a portion of the second gate.

Example 20 provides the IC device according to any one of example 19, where the first region has an opening between the portion of the first gate and the portion of the second gate.

Example 21 provides an IC package, including the device (IC device or varactor device) according to any one of examples 1-20; and a further IC component, coupled to the device.

Example 22 provides the IC package according to example 21, where the further IC component includes one of a package substrate, an interposer, or a further IC die.

Example 23 provides the IC package according to example 21 or 22, where the device (IC device or varactor device) according to any one of examples 1-20 may include, or be a part of, at least one of a memory device, a computing device, a wearable device, a handheld electronic device, and a wireless communications device.

Example 24 provides an electronic device, including a carrier substrate; and one or more of the device (IC device or varactor device) according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a substrate having a first surface and a second surface, the second surface opposite the first surface;
a layer comprising an electrically conductive material, wherein the layer is outside the substrate and is closer to the first surface than the second surface;
a structure comprising a semiconductor material having a dopant concentration of at least 10¹⁸ dopants per cubic centimeter (cm⁻³), wherein at least a portion of the structure is closer to the second surface than to the first surface;
a semiconductor region, at least of portion of which is closer to the second surface than to the first surface; and
a contact structure at least partially enclosed by the substrate, wherein the contact structure comprises an electrically conductive material, a first end of the contact structure is connected to the layer, and a second end of the contact structure is connected to the structure.

2. The IC device according to claim 1, wherein:
the semiconductor region comprises a plurality of semiconductor structures that are in parallel, or
a distance from the first surface to the second surface is in a range from 50 nanometers to 70 nanometers, or
the dopant concentration of the semiconductor material is a concentration of n-type dopants in the semiconductor material, or
the IC device is a varactor device.

3. The IC device according to claim 1 or 2, wherein:
the layer is a first layer,
the IC device further comprises a second layer comprising another electrically conductive material, and
the second layer is coupled to the semiconductor region.

4. The IC device according to claim 3, wherein:
the second layer is outside the substrate and is closer to the second surface than the first surface, or
the IC device further comprises a gate coupled to the second layer and to the semiconductor region.

5. The IC device according to one of the previous claims, wherein:
the semiconductor material is a first semiconductor material,
the semiconductor region comprises a second semiconductor material, and
a dopant concentration of the second semiconductor material is 10 to 1000 times lower than the dopant concentration of the semiconductor material.

6. The IC device according to one of the previous claims, further comprising:
an additional structure comprising an additional semiconductor material having a dopant concentration of at least 10¹⁸ cm⁻³, wherein at least a portion of the additional structure is closer to the second surface than to the first surface; and
an additional contact structure at least partially enclosed by the substrate, wherein a first end of the additional contact structure is connected to the layer, and a second end of the additional contact structure is connected to the additional structure,
wherein the semiconductor region is between the structure and the additional structure.

7. A varactor device, comprising:
a plurality of semiconductor structures, an individual semiconductor structure comprising a doped semiconductor material;
a plurality of contact structures, an individual contact structure comprising an electrically conductive material and is between a first electrically conductive layer and an individual semiconductor structure of the plurality of semiconductor structures; and
a plurality of semiconductor regions coupled to a second electrically conductive layer,
wherein an individual channel region is between two semiconductor structures of the plurality of semiconductor structures in a first direction, and the individual channel region is between the first electrically conductive layer and the second electrically conductive layer in a second direction.

8. The varactor device according to claim 7, further comprising:
a substrate between the first electrically conductive layer and the second electrically conductive layer,
wherein at least a portion of the individual contact structure is enclosed in the substrate.

9. The varactor device according to claim 7 or 8, wherein:
the first electrically conductive layer is a ground plane, or
the individual contact structure comprises a metal, or
an individual semiconductor region comprises a plurality of semiconductor ribbons.

10. An integrated circuit (IC) device, comprising:
a first section comprising:
a first layer comprising a first electrically conductive material,
a second layer comprising a second electrically conductive material,
a first semiconductor region comprising a first semiconductor material and coupled to the first layer, and
a second semiconductor region comprising a second semiconductor material and coupled to the second layer,
wherein the first semiconductor region is separated from the second semiconductor region; and
a second section comprising:
a third layer comprising a third electrically conductive material,
a structure comprising a doped semiconductor material, and
a contact structure comprising an electrically conductive material and being between the first layer and the structure.

11. The IC device according to claim 10, further comprising:
a substrate coupled to the first section and the second section,
wherein the substrate is between the first layer and the third layer.

12. The IC device according to claim 11, wherein:
the substrate comprises a first region and a second region,
the first region comprises a third semiconductor material,
the second region comprises a fourth semiconductor material, and
a dopant concentration of the third semiconductor material is two to three times greater than a dopant concentration of the fourth semiconductor material.

13. The IC device according to claim 12, further comprising:
a first gate coupled to the first semiconductor region; and
a second gate coupled to the second semiconductor region,
wherein the first region encloses a portion of the first gate and encloses a portion of the second gate.

14. The IC device according to claim 13, wherein the first region has an opening between the portion of the first gate and the portion of the second gate.
